(19) Europäisches Patentamt

European Patent Office

Office européen des brevets

(11) **EP 1 662 584 A2**

(12) **EUROPÄISCHE PATENTANMELDUNG**

(43) Veröffentlichungstag:
**31.05.2006 Patentblatt 2006/22**

(51) Int Cl.:
*H01L 33/00* (2006.01)          *H01S 5/14* (2006.01)
*H01S 5/183* (2006.01)

(21) Anmeldenummer: **05023175.2**

(22) Anmeldetag: **24.10.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **30.11.2004 DE 102004057802**

(71) Anmelder: **Osram Opto Semiconductors GmbH 93049 Regensburg (DE)**

(72) Erfinder:
• **Schmid, Wolfgang**
  **93180 Deuerling / Hillohe (DE)**
• **Wirth, Ralph**
  **93186 Pettendorf-Adlersberg (DE)**
• **Streubel, Klaus**
  **93164 Laaber (DE)**

(74) Vertreter: **Epping - Hermann - Fischer Patentanwaltsgesellschaft mbH Ridlerstrasse 55 80339 München (DE)**

(54) **Strahlungemittierendes Halbleiterbauelement**

(57) Es wird ein strahlungemittierendes Halbleiterbauelement angegeben, das eine Halbleiterschichtenfolge (1) mit einer zur Strahlungserzeugung vorgesehenen aktiven Zone (2) und einen ersten, der aktiven Zone nachgeordneten Spiegel aufweist, wobei der erste Spiegel eine Metallschicht (4) und eine auf der der aktiven Zone zugewandten Seite der Metallschicht (4) angeordnete Zwischenschicht (3) aus einem strahlungsdurchlässigen und elektrisch leitfähigen Material umfasst, das strahlungemittierende Halbleiterbauelement zum Betrieb mit einem optischen Resonator und zur Erzeugung überwiegend inkohärenter Strahlung als RCLED vorgesehen ist oder das strahlungemittierende Halbleiterbauelement zum Betrieb mit einem externen optischen Resonator und zur Erzeugung überwiegend kohärenter Strahlung als VECSEL vorgesehen ist.

# FIG 1A

EP 1 662 584 A2

**EP 1 662 584 A2**

**Beschreibung**

Die vorliegende Erfindung betrifft ein strahlungemittierendes Halbleiterbauelement nach dem Oberbegriff des Anspruchs 1.

Derartige strahlungemittierende Halbleiterbauelemente können beispielsweise als vertikalemittierende Halbleiterbauelemente realisiert werden. Die vertikale Emissionsrichtung verläuft hierbei in der Regel im Wesentlichen senkrecht zu einer lateralen Haupterstreckungsrichtung der Halbleiterschichtenfolge, insbesondere deren Oberfläche. Der erste Spiegel ist bei derartigen Bauelementen häufig als Braggspiegel zur gerichteten Reflexion von in der aktiven Zone erzeugter Strahlung ausgeführt.

Ein Braggspiegel enthält gewöhnlich mehrere Halbleiterschichtenpaare mit einer jeweiligen Schichtdicke von ungefähr $\lambda/(4n)$, wobei $\lambda$ die Wellenlänge der in der aktiven Zone erzeugten Strahlung und n den Brechungsindex der jeweiligen Halbleiterschicht angibt.

Meist ist der Braggspiegel hochreflektierend, etwa mit einer Reflektivität von 99% oder mehr ausgebildet, was in der Regel eine vergleichsweise hohe Zahl von Halbleiterschichtenpaaren, etwa 30 oder mehr erfordert, die in der Folge zu einer maßgeblichen Dicke des Braggspiegels und damit des Halbleiterbauelements führen.

Ein derartiges Bauelement kann als Laserbauelement mit einer vertikalen Emissionsrichtung ausgeführt sein, das zur Erzeugung kohärenter Strahlung mittels eines internen Resonators (VCSEL: Vertical Cavity Surface Emitting Laser) oder eines externen Resonators (VECSEL: Vertical External Cavity Surface Emitting Laser) vorgesehen ist. Bei einem VCSEL ist ein zweiter Spiegel für den internen Resonator in der Regel zusammen mit dem ersten Spiegel in der Halbleiterschichtenfolge monolithisch integriert. Für einen VECSEL wird der Halbleiterschichtenfolge ein externer Spiegel für den optischen Resonator nachgeordnet.

Weiterhin kann sich die im Betrieb eines derartigen Halbleiterbauelements in der aktiven Zone entstehende Verlustwärme nachteilig auf die Funktion des Bauelements auswirken. Eine gute Wärmeableitung aus dem Bauelement ist daher wünschenswert. Durch die zahlreichen Grenzflächen in einem hochreflektierenden Braggspiegel wird die Wärmeableitung von der aktiven Zone jedoch behindert. Dies ist insbesondere dann der Fall, wenn die Materialien des Braggspiegels ohnehin eine relativ geringe Wärmeleitfähigkeit besitzen und die Wärmeableitung durch die Vielzahl an Grenzflächen weitergehend beeinträchtigt wird.

Auch wird eine effiziente elektrische Kontaktierung des Bauelements durch den Braggspiegel hindurch aufgrund seiner maßgeblichen Dicke erschwert.

Aufgabe der vorliegenden Erfindung ist es, ein verbessertes strahlungemittierendes Halbleiterbauelement der eingangs genannten Art anzugeben, das insbesondere klein und kompakt sowie mit einer erhöhten Effizienz ausgebildet werden kann.

Diese Aufgabe wird durch ein strahlungemittierendes Halbleiterbauelement mit den Merkmalen des Anspruchs 1 gelöst. Vorteilhafte Weiterbildungen der Erfindung sind Gegenstand der abhängigen Ansprüche.

Ein strahlungemittierendes Halbleiterbauelement gemäß der vorliegenden Erfindung weist eine Halbleiterschichtenfolge mit einer zur Strahlungserzeugung vorgesehenen aktiven Zone und einen ersten, der aktiven Zone nachgeordneten Spiegel auf, wobei der erste Spiegel eine Metallschicht und eine auf der der aktiven Zone zugewandten Seite der Metallschicht angeordnete Zwischenschicht aus einem strahlungsdurchlässigen und elektrisch leitfähigen Material umfasst, wobei das strahlungemittierende Halbleiterbauelement zum Betrieb mit einem optischen Resonator und zur Erzeugung inkohärenter Strahlung als RCLED oder zum Betrieb mit einem externen optischen Resonator und zur Erzeugung kohärenter Strahlung als VECSEL vorgesehen ist.

Es sei angemerkt, dass auch ein Halbleiterbauelement, welches zur Erzeugung überwiegend inkohärenter bzw. überwiegend kohärenter Strahlung ausgebildet ist, als von der Erfindung umfasst angesehen werden kann.

Ein derartiger erster Spiegel mit der Metallschicht und der Zwischenschicht hat gegenüber einem reinen Braggspiegel den Vorteil einer verbesserten Wärmeableitung aus dem strahlungemittierenden Halbleiterbauelement. Ein Braggspiegel gleicher Reflektivität weist typischerweise mehr als 20 Halbleiterschichtenpaare auf. Eine derart hohe Anzahl von Halbleiterschichten aber kann wegen der Vielzahl von Grenzflächen die Wärmeabfuhr aus der aktiven Zone behindern und somit die Lebensdauer des Bauelements verkürzen.

Die Zahl der Grenzflächen bzw. der Halbleiterschichtenpaare kann bei der Erfindung wegen der hohen Reflektivität der Metallschicht vorteilhaft gering gehalten werden, wodurch die Wärmeableitung vorteilhaft verbessert werden kann. Ferner weisen Metalle gewöhnlich eine höhere Wärmeleitfähigkeit als die Materialien eines Braggspiegels auf, wodurch die Wärmeableitung noch weiter verbessert wird. Dies ist für die Effizienz und die Lebensdauer von Bauelementen mit hoher Verlustleistung bzw. Wärmeentwicklung, insbesondere einem VECSEL, von besonderem Vorteil.

Ein weiterer Vorteil der Erfindung besteht in der geringen Eindringtiefe, der in der aktiven Zone erzeugten Strahlung in die Metallschicht. Die Eindringtiefe in einen Braggspiegel gleicher Reflektivität ist wegen der hohen Anzahl der an der Reflexion beteiligten Halbleiterschichtenpaaren der Dicke $\lambda/(4n)$ deutlich größer als die Eindringtiefe in eine Metallschicht, die typischerweise kleiner als ein Viertel der Wellenlänge ist. Die Eindringtiefe in den Braggspiegel ist maßgeblich durch die Dicke des Braggspiegels bestimmt. Die Eindringtiefe in den Braggspiegel wächst in der Regel zunächst mit der Anzahl der Halbleiterschichtenpaare des Braggspiegels und kann gegen einen Wert konvergieren, der von einem Unterschied in den Brechungsindices der für die einzelnen Halbleiterschichten der Halbleiterschichtenpaare verwendeten Materialien bestimmt ist. Der Braggspiegel wirkt somit von der aktiven Zone aus gesehen als ein virtueller Spiegel gleicher Reflektivität und vernachlässigbarer Ausdehnung, der verglichen mit der Position einer benachbart zur aktiven Zone angeordneten ersten Schicht des Braggspiegels um die Eindringtiefe weiter von der aktiven Zone entfernt ist.

Aufgrund der geringen Eindringtiefe in die Metallschicht kann bei der Erfindung die aktive Zone mit Vorteil näher an einem dementsprechenden virtuellen ersten Spiegel positioniert werden als im Falle eines reinen Braggspiegels, wodurch die Effizienz des strahlungemittierenden Halbleiterbauelements gesteigert werden kann. Dies gilt insbesondere für eine RCLED (Resonant Cavity Light Emitting Diode), deren Effizienz maßgeblich von der Anordnung bzw. dem Abstand der aktiven Zone zum virtuellen ersten Spiegel beeinflusst wird. Eine Anordnung in einem wohldefinierten Abstand nahe am ersten Spiegel ist für eine RCLED von besonderem Vorteil. Eine Ausbildung des ersten Spiegels mit einer Metallschicht erhöht die Freiheitsgrade der Abstandswahl zum virtuellen ersten Spiegel und trägt so zur Effizienzsteigerung des Bauelements bei.

Im Gegensatz zu Lasern dient der optische Resonator einer RCLED nicht der Verstärkung einzelner Moden mittels stimulierter Emission, sondern die spontan emittierte Strahlung wird in erster Linie in eine Emissionsrichtung gerichtet. Verglichen mit einer aus einer herkömmlichen LED ohne Resonator ausgekoppelten Strahlung kann die aus dem Resonator einer RCLED ausgekoppelte Strahlung eine erhöhte Strahlungsleistung aufweisen. Eine RCLED ist in der Regel als oberflächenemittierendes Bauelement mit einer vertikalen Emissionsrichtung ausgeführt.

Es sei angemerkt, dass im Rahmen der Erfindung als Metallschicht auch eine metallische Schicht angesehen werden kann, was insbesondere auch eine Schicht, die eine Legierung enthält, umfasst. Eine aus Metall bestehende Schicht ist jedoch besonders geeignet.

Auch die im Vergleich zu einem reinen Braggspiegel geringe Richtungsabhängigkeit der Reflektivität der Metallschicht kann die Effizienz des strahlungemittierenden Halbleiterbauelements vorteilhaft beeinflussen. Die Reflektivität von Braggspiegeln ist meist im Bereich um ihre Oberflächennormale am größten und nimmt mit wachsendem Einfallswinkel zu dieser Normalen relativ stark ab. Die Reflektivität von Metallschichten dagegen ist über einen weiten Winkelbereich näherungsweise konstant, so dass auch unter einem großen Winkel einfallende Strahlung noch in hohem Maße reflektiert wird und aus dem Bauelement ausgekoppelt werden kann. Mittels der Metallschicht kann insbesondere auch unter vergleichsweise großen Winkeln auf die Metallschicht treffende Strahlung zuverlässig reflektiert werden. Auch derartige Strahlungsanteile mit großen Auftreffwinkeln können so vereinfacht vermehrt in die Emissionsrichtung gerichtet werden.

Die Halbleiterschichtenfolge, insbesondere die aktive Zone, enthält bevorzugt mindestens ein III-V-Halbleitermaterial, etwa ein Material aus den Materialsystemen $In_xGa_yAl_{1-x-y}P$, $In_xGa_yAl_{1-x-y}N$ oder $In_xGa_yAl_{1-x-y}As$, jeweils mit $0\leq x\leq 1$, $0\leq y\leq 1$ und $x+y\leq 1$. III-V Halbleitermaterialien zeichnen sich durch vorteilhaft hohe Quanteneffizienz aus und sind zur Strahlungserzeugung vom ultravioletten (z. B. $In_xGa_yAl_{1-x-y}N$) über den sichtbaren (z. B. $In_xGa_yAl_{1-x-y}N$ oder $In_xGa_yAl_{1-x-y}P$) bis in den infraroten Spektralbereich (z. B. $In_xGa_yAl_{1-x-y}As$) besonders geeignet. Weiterhin weist die in der aktiven Zone erzeugte Strahlung bevorzugt eine Wellenlänge im sichtbaren, insbesondere roten, Spektralbereich auf. Für diesen Spektralbereich ist das Materialsystem $In_xGa_yAl_{1-x-y}P$ besonders geeignet.

In einer bevorzugten Ausgestaltung der Erfindung umfasst die aktive Zone eine Einfach- oder Mehrfach-Heterostruktur, insbesondere eine Doppelheterostruktur, oder eine Quantentopfstruktur, insbesondere eine Mehrfach-Quantentopfstruktur. Mittels derartiger Strukturen kann eine vorteilhaft hohe interne Quanteneffizienz des Halbleiterbauelements erzielt werden.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Die Metallschicht des ersten Spiegels ist bevorzugt über die Zwischenschicht mit der Halbleiterschichtenfolge elektrisch leitend verbunden. Eine derartige Metallschicht kann neben der Reflexion von in der aktiven Zone erzeugter Strahlung zugleich an der elektrischen Kontaktierung des strahlungemittierenden Halbleiterbauelements beteiligt sein und bewirkt hierbei mit Vorteil eine homogene laterale Bestromung der aktiven Zone. Besonders bevorzugt enthält die Metallschicht Au, Ag, Al, Pt oder eine Legierung mit mindestens einem dieser Materialien. Hierbei weist Au im roten und A1 oder Ag auch im grünen und blauen Spektralbereich eine besonders hohe Reflektivität auf.

Ferner kann die Metallschicht auf einer Wärmesenke angeordnet sein, wodurch die Wärmeableitung aus dem Bauelement bzw. der aktiven Zone verbessert wird.

Die Zwischenschicht ist bei der Erfindung bevorzugt elektrisch leitend ausgebildet und weitergehend mit der Halbleiterschichtenfolge elektrisch leitend verbunden. Mit Vorteil weist das Material der Zwischenschicht eine höhere Haftung auf der Halbleiterschichtenfolge auf als das Material der Metallschicht und wirkt sich vorteilhaft auf den elektrischen Kontakt zwischen der Metallschicht und der Halbleiterschichtenfolge aus.

Besonders bevorzugt enthält die Zwischenschicht ein strahlungsdurchlässiges leitfähiges Oxid (Transparent Conducting Oxid, kurz: TCO), insbesondere ein Metalloxid, beispielsweise ein Zinkoxid, wie ZnO, ein Zinnoxid, wie SnO, ein Titanoxid, wie TiO, ein Indiumoxid, wie InO, oder ein Indiumzinnoxid, wie ITO. Derartige Materialien zeichnen sich durch eine hohe Leitfähigkeit, insbesondere in lateraler Richtung, und hohe Strahlungsdurchlässigkeit über einen weiten Wellenlängenbereich aus. Außerdem kann Zn bezüglich III-V-Halbleitern als Dotant, insbesondere Akzeptor, wirken und so den elektrischen Kontakt zur Halbleiterschichtenfolge, insbesondere einer an die Zwischenschicht angrenzenden p-leitenden Halbleiterschicht der Schichtenfolge, verbessern. Hierdurch kann, etwa durch Eindiffusion des Dotanten in die Halbleiterschichtenfolge, die Ausbildung eines barrierefreien oder ohmschen elektrischen Kontakts zur Halbleiterschichtenfolge erleichtert werden. Entsprechendes gilt für Sn als Donator bezüglich einer angrenzenden n-leitenden Schicht der Halbleiterschichtenfolge. Zur Erhöhung ihrer Leitfähigkeit kann die Zwischenschicht geeignet dotiert sein, zum Beispiel mit Al im Falle eines Zinkoxids oder Sb im Falle eines Zinnoxids.

Mit derartigen ersten Spiegeln können bereits hohe Reflektivitäten von über 90% bei gleichzeitig guten elektrischen Kontakteigenschaften und einer vorteilhaft geringen Dicke des Spiegels erreicht werden.

In einer bevorzugten Ausgestaltung ist die Zwischenschicht wenigstens teilweise derart ausgebildet ist, dass sich ein an der Metallschicht reflektierter Strahlungsanteil und ein an der der Halbleiterschichtenfolge zugewandten Seite der Zwischenschicht reflektierter Strahlungsanteil konstruktiv überlagern.

Durch diese Dimensionierung der Zwischenschicht wird die Effizienz des Bauelements erhöht, da destruktive Interferenzen, welche bei einer willkürlich dimensionierten Zwischenschicht auftreten können, vermieden werden. Diese Ausbildung der Zwischenschicht ist um so vorteilhafter, je höher der Brechungsindexunterschied zwischen dem Material der Zwischenschicht und dem auf Seiten der Halbleiterschichtenfolge angrenzenden Material ist, da mit steigendem Brechungsindexunterschied der an dieser Seite der Zwischenschicht reflektierte Strahlungsanteil steigt.

Die konstruktive Überlagerung der oben genannten Strahlungsanteile kann beispielsweise durch eine Ausbildung der Zwischenschicht mit einer geeigneten Dicke erzielt werden.

In einer bevorzugten Ausgestaltung ist die Zwischenschicht hierzu zumindest teilweise, vorzugsweise vollständig, so ausgeführt, dass ihre Dicke bis auf ganzzahlige Vielfache der Hälfte der Wellenlänge kleiner ist als ein Viertel der Wellenlänge der in der aktiven Zone erzeugten Strahlung in dem Material der Zwischenschicht. Für die Dicke D der Zwischenschicht gilt somit

$$D = \frac{\lambda}{4n_z} + k \cdot \frac{\lambda}{2n_z} - 1 \qquad , \qquad (1)$$

wobei $\lambda$ die Wellenlänge der in der aktiven Zone erzeugten Strahlung im Vakuum, $n_z$ der Brechungsindex der Zwischenschicht, k eine natürlichen Zahl (k=0,1,2,...) und 1 eine endliche, von Null verschiedene Restlänge ist.

Die Restlänge 1 ist bevorzugt kleiner als ein Viertel der Wellenlänge $\lambda$' $(\lambda/n_z)$, bevorzugt kleiner als ein Achtel der Wellenlänge $\lambda$', wobei $\lambda$' die Wellenlänge der in der aktiven Zone (2) erzeugten Strahlung in der Zwischenschicht (3) bezeichnet.

Zur Ausbildung einer kostruktiven Interferenz wird die Dicke der Zwischenschicht zumindest teilweise so gewählt, dass die an der Metallschicht und die an der der Halbleiterschichtenfolge zugewandten Seite der Zwischenschicht reflektierten Strahlungen einen Phasenunterschied von annähernd null oder geradzahligen Vielfachen von $\pi$ aufweisen. Dabei müssen eventuelle Phasensprünge durch Reflexion, wie etwa an der Metallschicht und an der der Halbleiterschichtenfolge zugewandten Seite der Zwischenschicht, berücksichtigt werden.

Ist der Brechungsindex $n_z$ der Zwischenschicht kleiner als der des auf Seiten der Halbleiterschichtenfolge angrenzenden Materials, erfüllt die Dicke D der Zwischenschicht für eine konstruktive Überlagerung senkrecht auf die Zwischenschicht einfallender Strahlungen vorzugsweise zumindest annähernd die Beziehung

$$D = \frac{\lambda}{4\pi \cdot n_z} \cdot (2k\pi + \Phi) = \frac{\lambda}{2n_z} \cdot \left(k + \frac{\Phi}{2\pi}\right) \qquad . \qquad (2)$$

Dabei ist $\lambda$ wiederum die Wellenlänge der in der aktiven Zone erzeugten Strahlung im Vakuum, k (k=0,1,2,...) eine natürliche Zahl und $\Phi$ der Phasensprung durch Reflexion an der Metallschicht. Der Faktor $\lambda/(4\pi \cdot n_z)$ entspricht dem Phasenbeitrag $2D \cdot (2\pi \cdot n_z)/\lambda$, der durch den doppelten Durchgang von an der Metallschicht reflektierter Strahlung durch die Zwischenschicht der Dicke D entsteht.

Ist der Brechungsindex $n_z$ der Zwischenschicht größer als der des auf Seiten der Halbleiterschichtenfolge angrenzenden Materials, so ist wegen des zusätzlichen Phasensprungs von $\pi$ aus der Reflexion an einem optisch dichteren Medium der Term 2kπ durch (2k+1)π zu ersetzen, so dass in diesem Fall für die Dicke D der Zwischenschicht mit Vorzug zumindest annähernd gilt:

$$D = \frac{\lambda}{4\pi \cdot n_z} \cdot \left((2k+1)\pi + \Phi\right) = \frac{\lambda}{2n_z} \cdot \left(k + \frac{1}{2} + \frac{\Phi}{2\pi}\right) \qquad (2')$$

Eine ideale Metallschicht besitzt eine unbegrenzte Leitfähigkeit, so dass sich bei Reflexion einer elektromagnetischen Welle ein Phasensprung von $\pi$ ergibt. Nach Gleichung (2) beträgt die Dicke $D_{id}$ der Zwischenschicht für eine solche ideale Metallschicht

$$D_{id} = \frac{\lambda}{4n_z} + k \cdot \frac{\lambda}{2n_z} \qquad . \qquad (3)$$

Ein reales Metall besitzt demgegenüber nur endliche Leitfähigkeit und der Phasensprung durch Reflexion an der Metallschicht ergibt sich beispielsweise aus den Fresnelschen Formeln unter Benutzung des komplexen Brechungsindexes des realen Metalls. Die Dicke der Zwischenschicht $D_{re}$ auf einer realen Metallschicht ergibt sich nach (2) zu

$$D_{re} = \frac{\lambda}{2n_z} \cdot \left(k + \frac{\Phi_{re}}{2\pi}\right) \qquad . \qquad (4)$$

Die Dicke $D_{re}$ der Zwischenschicht für eine reale Metallschicht weicht bevorzugt um ungefähr

$$d_M = D_{id} - D_{re} = \frac{\lambda}{2n_z} \cdot \frac{\left(\pi - \Phi_{re}\right)}{2\pi} \qquad (5)$$

von der Dicke $D_{id}$ auf einer ideal leitenden Metallschicht ab, damit konstruktive Interferenz erreicht wird.
Da die Phase, die auf eine reale Metallschicht einfallende Strahlung bei Reflexion erfährt in der Regel positiv sind, ist auch $d_M$ meist positiv.
Die Größe $d_M$ kann im Rahmen der Erfindung als Eindringtiefe in die Metallschicht angesehen werden, die die Position des entsprechenden virtuellen ersten Spiegels bestimmt oder mitbestimmt. Diese Eindringtiefe ist für reale Metalle gewöhnlich kleiner als eine viertel Wellenlänge, oftmals kleiner als eine achtel Wellenlänge, der in der aktiven Zone erzeugten Strahlung in der Zwischenschicht.
Weiterhin weichen die Eindringtiefe $d_M$ und die Restlänge 1 bevorzugt um 20 nm oder weniger, besonders bevorzugt um 10 nm oder weniger voneinander ab. Insbesondere können die Restlänge und die Eindringtiefe auch um weniger als 5 nm voneinander abweichen oder übereinstimmen.
Die Phase $\Phi_{re}$, die die an der realen Metallschicht reflektierte Strahlung erfährt, kann demnach durch eine entsprechende Dicke der Zwischenschicht derart kompensiert werden, dass die an der Metallschicht und an der der Halbleiterschichtenfolge zugewandten Seite der Zwischenschicht reflektierten Strahlungsanteile einen Phasenunterschied aufweisen, der zumindest annähernd gleich null oder ganzzahligen Vielfachen von n ist. Der Phasenunterschied von null wird dadurch möglich, dass die Phase durch Reflexion an der Metallschicht und die durch den Durchgang der Strahlung durch die Zwischenschicht verursachte Phase entgegengesetzte Vorzeichen aufweisen können. Dies gilt insbesondere für positive Phasen $\Phi$ bzw. $\Phi_{re}$ durch Reflexion an der Metallschicht.
In einer vorteilhaften Weiterbildung der Zwischenschicht ist deren Dicke D durch Gleichung (1) mit k=0 gegeben und die Restlänge 1 nach einer der obigen Maßgaben bestimmt. Die Dicke D der Zwischenschicht weicht somit um die Restlänge 1 von $\lambda/(4n_z)$ ab.
Dies hat den Vorteil, dass die Dicke der Zwischenschicht beim Aufbringen leichter kontrollierbar ist, da bei einer geringen Schichtdicke der Zwischenschicht etwaige Unregelmäßigkeiten in der Dicke leichter zu detektieren und damit zu kontrollieren sind als bei Schichtdicken mit größeren k-Werten und gleichen Restlängen 1. Weiterhin wird die Dicke des ersten Spiegels dadurch vorteilhaft gering gehalten.

Der optische Resonator kann bei der Erfindung als interner oder externer Resonator ausgebildet sein.

Bevorzugt ist der Resonator durch den ersten und einen zweiten Spiegel gebildet, der auf der dem ersten Spiegel abgewandten Seite der aktiven Zone angeordnet ist. Besonders bevorzugt ist die Reflektivität des zweiten Spiegels kleiner als die des ersten Spiegels, wobei weiter bevorzugt der zweite Spiegel einen Auskoppelspiegel des strahlungemittierenden Halbleiterbauelements bildet. Eine effektive Resonatorlänge des Halbleiterbauelements ist durch den Abstand des ersten und des zweiten virtuellen Spiegels bestimmt. Eine kleine effektive Resonatorlänge ist insbesondere für eine RCLED von Vorteil.

Ein interner Resonator kann bei der Erfindung zum Beispiel mit einem Braggspiegel als zweitem Spiegel gebildet werden, der bevorzugt als Teil der Halbleiterschichtenfolge ausgebildet und in dieser integriert ist.

Ein externer Resonator kann bei der Erfindung beispielsweise mit einem dielektrischen Spiegel als zweiten Spiegel gebildet werden, der von der Halbleiterschichtenfolge beabstandet angeordnet ist.

Bei Laserbauelementen, wie VCSELn oder VECSELn, ist die für eine Lasertätigkeit notwendige Reflektivität des Auskoppelspiegels meist größer als 98%. Verbleibende, nicht der Auskopplung dienende Resonatorspiegel erfordern, um das Erreichen einer Lasertätigkeit zu sichern, oftmals noch höhere Reflektivitäten.

Die Reflektivität des Auskoppelspiegels ist bei einer RCLED, die bevorzugt einen internen Resonator aufweist, gewöhnlich geringer als bei einem Laser, da eine RCLED für eine hohe Auskoppeleffizienz ausgebildet ist, die durch einen hochreflektierenden Auskoppelspiegel, wie bei Lasern üblich oder notwendig, unnötig vermindert würde. Typische Reflektivitäten des Auskoppelspiegels liegen bei 90 % oder weniger, bevorzugt 80 % oder weniger, besonders bevorzugt 70 % oder weniger. Auch eine Reflektivität von 60 % oder weniger kann sich als geeignet erweisen.

In einer weiteren bevorzugten Ausgestaltung der Erfindung umfasst der erste Spiegel zusätzlich zur Metall- und der Zwischenschicht einen Braggspiegel, der auf der der aktiven Zone zugewandten Seite der Zwischenschicht, vorzugsweise zwischen der Zwischenschicht und der aktiven Zone, angeordnet ist. Insbesondere kann der Braggspiegel in der Halbleiterschichtenfolge integriert sein.

Dieser Braggspiegel enthält vorzugsweise weniger als 20, dabei bevorzugt weniger als 6 und besonders bevorzugt weniger als 4 Halbleiterschichtenpaare. Ein derartiger zusätzlicher Braggspiegel erhöht mit Vorteil die Reflektivität des ersten Spiegels.

Durch die Kombination aus Metallschicht, Zwischenschicht und zusätzlichem Braggspiegel kann ein erster Spiegel gebildet werden, der verglichen mit einem nur von Halbleiterschichtenpaaren gebildetem Braggspiegel gleicher Reflektivität eine wesentlich geringere Zahl von Halbleiterschichtenpaaren enthält und eine geringere Dicke aufweist. Für eine gerichtete Emission bei einer effizienten (RC)LED ist ein derartiger dünner, hochreflektierender Spiegel von besonderem Vorteil. Bei VCSEL oder VECSEL beispielsweise werden für einen reinen Braggspiegel meist mehr als 20 Halbleiterschichtenpaare benötigt, um eine häufig notwendige Reflektivität von mehr als 98% zu erreichen.

Im Rahmen der Erfindung kann die Anzahl der Halbleiterschichtenpaare demgegenüber geringer gehalten werden. Eine Reflektivität von 98% etwa, kann durch einen zusätzlichen Braggspiegel mit 3 Halbleiterschichtenpaaren in Verbindung mit der Metallschicht und der Zwischenschicht erreicht werden.

Von besonderem Vorteil ist ein derartiger erster Spiegel, falls die für einen monolithisch integrierbaren Braggspiegel zur Verfügung stehenden Materialien nur vergleichsweise geringe Brechungsindexunterschiede aufweisen und somit eine entsprechend hohe Zahl von Halbleiterschichtenpaaren dieses Brechungsindexunterschiedes zum Erreichen einer hohen Reflektivität nötig wäre.

Die Eindringtiefe in den ersten Spiegel und die Dicke des ersten Spiegels können so bei hoher Reflektivität des ersten Spiegels vorteilhaft verringert werden. Dies kann sich positiv auf die Effizienz des strahlungemittierenden Halbleiterbauelements, insbesondere einer RCLED, auswirken.

Die vergleichsweise geringe Zahl von Halbleiterschichtenpaaren eines zusätzlichen Braggspiegels führt weiterhin nicht nur zu einer vorteilhaft verbesserten Wärmeableitung, sondern auch zu verkürzten Herstellungszeiten, insbesondere Epitaxiezeiten, für die Halbleiterschichtenfolge, die den Braggspiegel des ersten Spiegels umfassen kann.

Der oder die Braggspiegel enthalten bei der Erfindung vorzugsweise ein für die in der aktiven Zone erzeugte Strahlung geeignetes III-V-Halbleitermaterial, besonders bevorzugt $In_xGa_yAl_{1-x-y}P$, $In_xGa_yAl_{1-x-y}N$ oder $In_xGa_yAl_{1-x-y}As$, jeweils mit $0\leq x\leq 1$, $0\leq y\leq 1$ und $x+y\leq 1$.

In einer bevorzugten Ausgestaltung der Erfindung ist die Halbleiterschichtenfolge mit der aktiven Zone durch epitaktisches Aufwachsen auf einem Aufwachssubstrat hergestellt. Nachfolgend wird zunächst die Zwischenschicht und danach die Metallschicht, zum Beispiel jeweils durch Sputterdeposition oder Aufdampfen, auf die dem Aufwachssubstrat abgewandte Seite der Halbleiterschichtenfolge aufgebracht. Die Halbleiterschichtenfolge wird nachfolgend auf ihrer dem Aufwachssubstrat abgewandten Seite mit einem geeigneten Träger verbunden. Die Verbindung ist bevorzugt elektrisch leitend ausgebildet und/oder erfolgt mittels der Metallschicht. Die Metallschicht kann auf den Träger gebondet, etwa mittels eutektischem Bonden mit geeigneten Metallschichten, gelötet oder geklebt, etwa mittels eines, vorzugsweise elektrisch leitend ausgebildeten, Klebstoffs, werden. Eine sich bei der Verbindung ausbildende Verbindungsschicht ist mit Vorzug zwischen der Metallschicht und dem Träger angeordnet. Das Aufwachssubstrat wird nachfolgend abgelöst und der Verbund aus Träger, Metallschicht, Zwischenschicht und Halbleiterschichtenfolge durch ein geeignetes Trennverfahren - beispielsweise trockenchemisches Mesa-Ätzen und nachfolgendes Sägen - in Bauelemente, die jeweils einen Teil der Halbleiterschichtenfolge (Mesa) umfassen, vereinzelt.

Derartige, mittels Ablösen des Aufwachssubstrats und Befestigung auf einem Träger hergestellte strahlungemittierende Halbleiterbauelemente werden auch als Dünnfilm-Bauelemente bezeichnet.

Der Träger kann weiterhin als, insbesondere metallhaltige, Wärmesenke ausgebildet sein, wodurch die Wärmeabfuhr von der aktiven Zone verbessert wird.

In einer vorteilhaften Weiterbildung der Erfindung ist auf der dem ersten Spiegel abgewandten Seite der aktiven Zone eine Kontaktstruktur zur elektrischen Kontaktierung des strahlungemittierenden Halbleiterbauelements, vorzugsweise in Form einer Kontaktmetallisierung, angeordnet. Unter einem Bereich der aktiven Zone, insbesondere auf ihrer der Kontaktstruktur abgewandten Seite, der von der Kontaktstruktur überdeckt wird, insbesondere in einem der Kontaktstruktur in vertikaler Richtung nachgeordneten Bauelementbereich, ist bevorzugt eine elektrische Isolationsschicht angeordnet. Besonders bevorzugt ist die Isolationsschicht in einer Ausnehmung oder Aussparung des ersten Spiegels angeordnet, die dieser im Bereich, der von der Kontaktstruktur überdeckt wird, aufweisen kann.

Eine derartige Isolationsschicht vermindert mit Vorteil die Injektion von Strom in den Bereich der aktiven Zone, der von der Kontaktstruktur überdeckt wird. Dadurch wird in diesem Bereich der aktiven Zone eine verglichen mit den übrigen Bereichen geringe Strahlungsleistung erzeugt. Somit kann in der eventuell absorbierenden Kontaktstruktur auch nur in geringerem Maße Strahlung absorbiert werden, wodurch die Effizienz des strahlungemittierenden Halbleierbauelements vorteilhaft erhöht wird.

Die Isolationsschicht enthält beispielsweise ein Siliziumnitrid, wie SiN, oder andere geeignete Materialien.

Weiterhin kann in dem zwischen der aktiven Zone und dem ersten Spiegel angeordneten Teil der Halbleiterschichtenfolge ein Graben ausgebildet sein, der vorzugsweise die in die Ebene dieses Teils der Halbleiterschichtenfolge projizierte Kontaktstruktur, insbesondere vollständig, umläuft. Dieser Graben ist bevorzugt zumindest teilweise, besonders bevorzugt vollständig, mit dem Material der Isolationsschicht ausgefüllt. Ein vom Graben umschlossener Bereich des zwischen dem ersten Spiegel und der aktiven Zone angeordneten Teils der Halbleiterschichtenfolge ist demnach elektrisch von der Kontaktstruktur getrennt. Eine Strahlungserzeugung unter der Kontaktstruktur wird hierdurch verringert. Der Graben kann sich in vertikaler Richtung von der an die Zwischenschicht angrenzenden Seite der Halbleiterschichtenfolge bis zum Rand der aktiven Zone oder gegebenenfalls bis in die aktive Zone erstrecken.

Weitere Merkmale, Vorteile und Zweckmäßigkeiten der Erfindung ergeben sich aus den Beschreibungen der folgenden Ausführungsbeispiele in Verbindung mit den folgenden Figuren.

Es zeigen

Figur 1a  eine schematische Schnittansicht eines erstes Ausführungsbeispiels eines erfindungsgemäßen strahlungemittierenden Halbleiterbauelements,

Figur 1b  eine schematische Schnittansicht eines Ausführungsbeispiels für eine Halbleiterschichtenfolge in einem erfindungsgemäßen strahlungemittierenden Halbleiterbauelements und

Figur 2  eine schematische Schnittansicht eines zweiten Ausführungsbeispiels eines erfindungsgemäßen strahlungemittierenden Halbleiterbauelements.

Gleiche, gleichartige und gleich wirkende Elemente sind in den Figuren mit gleichen Bezugszeichen versehen.

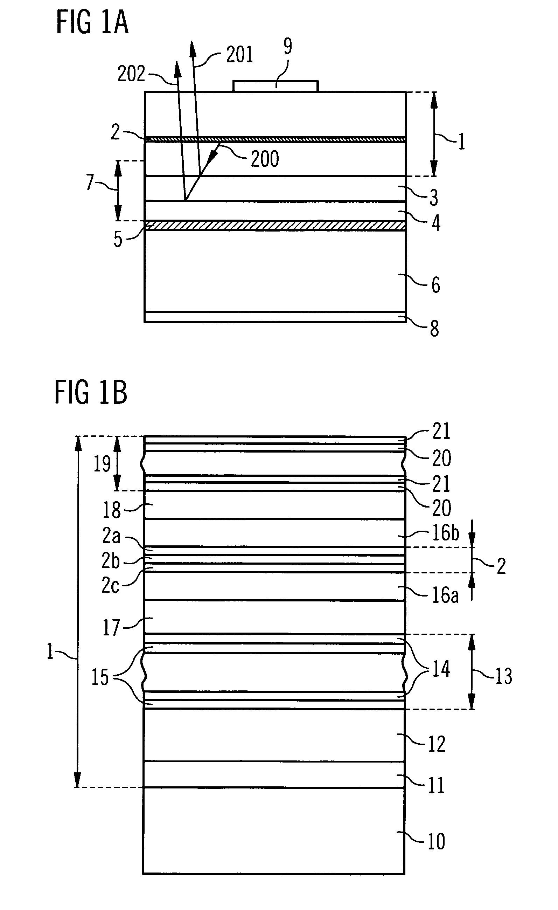

In der Figur 1a ist eine schematische Schnittansicht eines ersten Ausführungsbeispiels eines erfindungsgemäßen strahlungemittierenden Halbleiterbauelements dargestellt.

Einer Halbleiterschichtenfolge 1 mit einer Strahlung erzeugenden aktiven Zone 2 ist eine elektrisch leitende und strahlungsdurchlässige Zwischenschicht 3 und dieser wiederum eine Metallschicht 4 nachgeordnet. Die Metallschicht 4 ist über eine Verbindungsschicht 5 mit einem Träger 6 verbunden.

Die Metallschicht 4 und die Zwischenschicht 3 sind Teil eines ersten Spiegels 7 des strahlungemittierenden Halbleiterbauelements.

Die elektrische Kontaktierung des Bauelements erfolgt in diesem Ausführungsbeispiel über die Elektroden 8 und 9. Da die Elektrode 8 auf der dem ersten Spiegel 7 abgewandten Seite des Trägers 6 angeordnet ist, ist dieser zur Erhöhung seiner Leitfähigkeit vorzugsweise dotiert oder weist von sich aus eine entsprechend hohe Leitfähigkeit auf. Die Halbleiterschichtenfolge 1 ist über die Metallschicht 4, die elektrisch leitende und strahlungsdurchlässige Zwischenschicht 3, den Träger 6 und die Verbindungsschicht 5 mit der Elektrode 8 elektrisch leitend verbunden.

Im Betrieb des Bauelements in der aktiven Zone 2 erzeugte Strahlung 200 verlässt die aktive Zone in Richtung des ersten Spiegels 7. Ein erster Strahlungsanteil 201 wird an der Grenzfläche der Zwischenschicht 3 zur Halbleiterschichtenfolge 1 reflektiert und ein weiterer Strahlungsanteil 202 wird an der Metallschicht 4 reflektiert. Bevorzugt ist die Zwischenschicht derart ausgebildet, dass sich die Strahlungsanteile 201 und 202 konstruktiv überlagern. Die Reflexion am ersten Spiegel kann so besonders effizient genutzt werden.

Eine für konstruktive Überlagerung geeignete Dicke D bzw. $D_{re}$ der Zwischenschicht kann hierzu entsprechend den weiter oben angegebenen Maßgaben bestimmt und die Zwischenschicht dementsprechend dimensioniert sein.

Mit einem derartigen ersten Spiegel 7 können, insbesondere im sichtbaren Spektralbereich, bereits Reflektivitäten von über 90% erreicht werden.

Sind höhere Reflektivitäten des ersten Spiegels erforderlich, kann in der Halbleiterschichtenfolge 1 auf der Seite der Zwischenschicht 3 ein Braggspiegel integriert sein, um die Reflektivität des ersten Spiegels 7 zu erhöhen. Dies ist in Figur 1a durch eine Erstreckung des ersten Spiegels 7 bis in die Halbleiterschichtenfolge angedeutet. Dabei sind in einem derartigen ersten Spiegel weniger Halbleiterschichtenpaare notwendig als bei einem ausschließlich als Braggspiegel ausgebildetem ersten Spiegel gleicher Reflektivität. Durch die geringere Anzahl an Grenzflächen und die verglichen mit dem Halbleitermaterial der Braggspiegels im allgemeinen höheren Wärmeleitfähigkeit der Metallschicht, wird die Wärmeableitung aus dem Bauelement verbessert. Bevorzugt ist hierbei der Träger 5 als Wärmesenke ausgebildet.

Je nach Ausführung der Halbleiterschichtenfolge 1 und/oder des Resonators kann ein derartiges Bauelement als kohärente Laserstrahlung emittierendes Bauelement in Form eines VECSEL oder als inkohärente Strahlung aus spontaner Emission emittierendes Bauelement in Form einer RCLED, etwa mit internem Resonator (nicht dargestellt, vgl. Figur 1b), realisiert werden. Weiterhin eignet sich die Erfindung auch für weitere Halbleiterbauelemente, etwa einen Laser, wie einen VCSEL mit internem Resonator, oder eine LED ohne Resonator.

Ein optischer Resonator des Bauelements kann als interner Resonator, insbesondere für eine RCLED, oder als externer Resonator, insbesondere für einen VECSEL, mit dem ersten und einem zweiten Spiegel gebildet sein. Für ein Laserbauelement, insbesondere einen VECSEL, ist die Elektrode 8, abweichend von der Darstellung, bevorzugt als Ringelektrode am Rand der Halbleiterschichtenfolge mit einem von der Elektrode freien Zentralbereich der Halbleiterschichtenfolge ausgeführt.

In der Figur 1b ist eine schematische Schnittansicht eines Ausführungsbeispiels einer Halbleiterschichtenfolge 1 eines erfindungsgemäßen strahlungemittierenden Halbleiterbauelements, wie sie in Figur 1a ausgebildet sein kann, dargestellt.

In diesem Beispiel ist eine Halbleiterschichtenfolge 1 für eine RCLED dargestellt.

Die Halbleiterschichtenfolge 1, deren aktive Zone 2 beispielsweise auf dem III-V-Halbleitermaterialsystem $In_x$ $Ga Al_{1-x-y} P$, mit $0 \le x \le 1$, $0 \le y \le 1$ und $x+y \le 1$, basiert, ist vorzugsweise auf einem Aufwachssubstrat 10, etwa GaAs, epitaktisch gewachsen. Auf dem Aufwachssubstrat 10 ist eine Ätzstopschicht 11, vorzugsweise aus $In_{0,5}Al_{0,25}Ga_{0,25}P$, angeordnet, die nachteiligen Auswirkungen der Einwirkung eines Ätzmittels auf die nachfolgenden Schichten vorbeugt. Der auf dieser Schicht gewachsenen typischerweise 1-10 $\mu m$ dicken Stromaufweitungsschicht 12, beispielsweise aus n-leitendem $Al_{0,8}Ga_{0,2}As$, folgt ein Braggspiegel 13 mit beispielsweise 4 bis 10 Halbleiterschichtenpaaren, die jeweils eine Schicht 14 mit niedrigem Brechungsindex, vorzugsweise aus n-leitendem $Al_{0,95}Ga_{0,05}As$ und eine Schicht 15 mit höherem Brechungsindex, zum Beispiel aus n-leitendem $Al_{0,5}Ga_{0,5}As$, umfassen, wobei die hochbrechende Schicht 14 des jeweiligen Paares vorzugsweise seitens der aktiven Zone 2 angeordnet ist. Die Schichtdicke der jeweiligen Schichten des Braggspiegels 13 ist dabei durch ungefähr ein Viertel der Wellenlänge der erzeugten Strahlung in dieser Schicht gegeben.

Um die aktive Zone 2 herum, die eine Schichtenfolge 2a, 2b, 2c , beispielsweise in der Reihenfolge $In_{0,6}Ga_{0,4}P$, $In_{0,5}Ga_{0,25}Al_{0,25}P$ und wiederum $In_{0,6}Ga_{0,4}P$, mit der jeweiligen Dicke von ungefähr 5 nm umfasst, und zum Beispiel als Doppelheterostruktur oder Quantenfilmpaket ausgeführt ist, sind eine n-leitende Wellenleiterschicht 16a und eine p-leitende Wellenleiterschicht 16b, vorzugsweise jeweils aus $In_{0,5}Ga_{0,25}Al_{0,25}P$, angeordnet, von denen die Schicht 16a über eine n-leitende Barrierenschicht 17, etwa aus $n-In_{0,5}Al_{0,5}P$, mit dem Braggspiegel 13 verbunden ist. Die Wellenleiterschicht 16b ist mit der p-leitenden Seite der Halbleiterschichtenfolge 1 über eine p-leitende Barrierenschicht 18, zum Beispiel aus $p-In_{0,5}Al_{0,5}P$, verbunden. Dieser nachgeordnet ist ein dem Braggspiegel 13 entsprechend ausgeführter p-leitender Braggspiegel 19, der zum Beispiel 4 oder weniger Halbleiterschichtenpaare, insbesondere ein Paar bis 4 Paare, mit einer niedrigbrechenden Schicht 20, zum Beispiel aus p-leitendem $Al_{0,95}Ga_{0,05}As$, und einer Schicht 21 mit höherem Brechungsindex, wie etwa aus p-leitendem $Al_{0,5}Ga_{0,5}As$, umfasst.

Die Barriereschichten 17 und 18 dienen dem Einschluss von Ladungsträgern in der aktiven Zone, was in einer erhöhten Ladungsträger-Rekombination in der aktiven Zone und somit einer erhöhten Effizienz des Bauelements resultiert.

Nach dem epitaktischen Wachsen der in Figur 1b gezeigten Halbleiterschichtenfolge auf dem Aufwachssubstrat 10 kann p-seitig eine strahlungsdurchlässige und elektrisch leitfähige Zwischenschicht 3, wie in Figur 1a gezeigt, beispielsweise aus ZnO, vorzugsweise mit Al dotiert, aufgebracht werden. Dies kann ebenso wie das nachfolgende Aufbringen der Metallschicht 4, etwa einer Au-Schicht, zum Beispiel durch Sputtern oder Aufdampfen geschehen.

Eine derartige Zwischenschicht 3 verbessert mit Vorteil die Haftung der Au-Schicht auf der Halbleiterschichtenfolge durch eine gegenüber Au erhöhte Haftung auf dem angrenzenden III-V-Halbleitermaterial. Weiterhin verbessert die Zwischenschicht mit Vorteil den elektrischen Kontakt der Au-Schicht zur Halbleiterschichtenfolge, vorzugsweise durch Diffusion von Zn-Atomen, die als Akzeptoren wirken können, in den angrenzenden III-V-Halbleiter. Dadurch wird eine homogene verlustarme Bestromung der aktiven Zone 2 von der p-Seite her gewährleistet, da sowohl die Metallschicht 4, als auch die Zwischenschicht 3 eine hohe Leitfähigkeit, insbesondere in lateraler Richtung, besitzen. Eine p-leitende AlGaAs-haltige Halbleiterschicht ist zur Ausbildung eines ohmschen Kontakts zur Halbleiterschichtenfolge mittels einer an die Halbleiterschicht angrenzenden ZnO-haltigen Zwischenschicht besonders geeignet.

Auf der n-Seite der Halbleiterschichtenfolge wird eine homogene Stromverteilung durch die Stromaufweitungsschicht 12 in der Halbleiterschichtenfolge 1 erreicht. Verglichen mit einem Bauelement mit zwei - einer n-seitigen und einer p-seitigen - in der Halbleiterschichtenfolge 1 ausgebildeten Stromaufweitungsschichten kann hierbei die Epitaxiezeit verkürzt werden.

Nachfolgend kann die Metallschicht über eine Verbindungsschicht 5, beispielsweise eine Lot- oder Bondschicht, mit dem Träger 6 verbunden werden, der mit Vorzug GaAs enthält und/oder als Wärmesenke ausgebildet ist. Wird die Halbleiterschichtenfolge mittels eutektischem Bonden mit geeigneten Metallschichten auf dem Träger befestigt, kann die Verbindungsschicht gegebenenfalls ein Mehrschichtsystem umfassen. Danach werden das Aufwachssubstrat 10, beispielsweise durch Ätzen, mechanische Belastung oder ein Laserablöseverfahren, abgelöst und die Elektroden 8, 9, beispielsweise in Form von Kontaktmetallisierungen, auf der Halbleiterschichtenfolge und der dieser abgewandten Seite des Trägers angeordnet.

Die Metallschicht 4, die Zwischenschicht 3 und der p-seitige Braggspiegel 19 bilden den ersten Spiegel 7 der RCLED, der zusammen mit dem n-seitigen Braggspiegel 13 den internen optischen Resonator des Bauelements darstellt.

Wegen der stark absorbierenden Struktur mit der Metallschicht 4 und dem GaAs-Träger 6, ist zweckmäßigerweise der auf der dem Träger abgewandten Seite der aktiven Zone angeordnete zweite Spiegel 13 als Auskoppelspiegel ausgebildet.

Die Emissionswellenlänge $\lambda$ einer derartigen RCLED liegt im sichtbaren, beispielsweise im roten Spektralbereich, etwa bei ungefähr 650 nm.

Die Dicke der Zwischenschicht beträgt für diese Wellenlänge ungefähr 70 nm. Die Dicke der Zwischenschicht ist damit um die Eindringtiefe $d_M \approx 30nm$ gegenüber der Dicke $D_{id} = \lambda/(4n_z) \approx 100nm$ der Zwischenschicht für eine ideale Metallschicht reduziert, wobei der Brechungsindex $n_z$ der Zwischenschicht bei der obigen Wellenlänge für ZnO ungefähr 1,6 beträgt. Die Eindringtiefe $d_M$ ergibt sich dabei nach Gleichung (5) mit der Phase $\Phi_{re} \approx 2,2$ durch die Reflexion an der Au-Schicht, die sich aus den Fresnelschen Formeln mit dem komplexen Brechungsindex von Au, der einen hohen Imaginärteil aufweist, berechnet.

Dadurch wird mit Vorteil erreicht, dass ein möglichst hoher Anteil der an der der aktiven Zone 2 zugewandten Seite der Zwischenschicht 3 und der an der Metallschicht 4 reflektierten Strahlungsanteile konstruktiv interferiert und die Reflektivität des ersten Spiegels 7 nicht durch destruktive Interferenz verringert wird.

Der Braggspiegel 13 hat mit Vorteil eine Reflektivität von 90% oder weniger, um insbesondere die Auskoppeleffizienz der spontan emittierten Strahlung nicht zu verringern, die bei RCLEDs unter anderem auch von der Reflektivität des Auskoppelspiegels beeinflusst wird.

Der erste Spiegel 7 dagegen hat bei einer derartigen Ausgestaltung der Halbleiterschichtenfolge 1 eine höhere Reflektivität von ungefähr 98% und eine vorteilhaft geringe Eindringtiefe, so dass die Dicke verglichen mit einem reinen Braggspiegel gleicher Reflektivität, der für $\lambda \approx 650nm$ ungefähr 23 der oben genannten Halbleiterschichtenpaare umfassen müsste, reduziert ist. Die aktive Zone 2 kann somit nahe am virtuellen ersten Spiegel angeordnet werden, wodurch die Effizienz der RCLED vorteilhaft erhöht wird.

Ferner ist die aktive Zone 2 im Resonator bevorzugt so angeordnet, dass sie sich im Betrieb des Bauelements in einem Wellenbauch einer sich im Resonator ausbildenden stehenden Welle befindet. Die Effizienz des strahlungemittierenden Bauelements kann so durch Ankopplung an die maximale elektrische Feldstärke der stehenden Welle weiter erhöht werden. Insbesondere ist bei der Positionierung der aktiven Zone 2 die im Betrieb des Bauelements entstehende Wärme und die daraus resultierende Ausdehnung der einzelnen Bestandteile des Bauelements, insbesondere in der Halbleiterschichtenfolge, zu beachten, so dass die aktive Zone im Betrieb des Bauelements in einem Wellenbauch angeordnet ist.

Ein weiterer Vorteil eines derartigen ersten Spiegels 7 liegt in der geringen Richtungsabhängigkeit der Reflektivität an der Metallschicht 4, die nahezu unabhängig vom Einfallswinkel der Strahlung relativ zur Oberflächennormalen des Spiegels ist. Strahlung, die die aktive Zone unter einem großen Winkel zur Oberflächennormalen verlässt, kann von einem reinen Braggspiegel dagegen nicht oder nur schlecht reflektiert und damit auch nur in geringem Maße aus dem Bauelement ausgekoppelt werden.

An der Metallschicht 4 aber wird auch unter einem großen Winkel einfallende Strahlung in hohem Maße reflektiert. Diese kann nachfolgend von der aktiven Zone 2 absorbiert und eventuell so reemittiert werden, dass sie aus dem Bauelement ausgekoppelt wird (sogenanntes Photonen-Recycling). Auf diese Weise wird insbesondere bei einer aktiven Zone 2 mit hoher Quanteneffizienz, wie sie bei InGalP-basierenden Bauelementen realisierbar sind, die Wahrscheinlichkeit erhöht, dass ein einmal erzeugtes Photon ausgekoppelt wird. Insbesondere gilt dies auch für Photonen, die andernfalls einer fortgesetzten Totalreflexion im Resonator unterliegen würden, die auch bei vergleichsweise großen Winkeln - größer dem Grenzwinkel der Totalreflexion - auftritt. Die Effizienz der RCLED wird so weitergehend verbessert.

Es sei angemerkt, dass die Halbleiterschichtenfolge unter geringfügigen strukturellen Änderungen auch für einen VECSEL, einen VCSEL oder eine LED mit einem ersten Spiegel ohne Resonator ausgebildet werden kann.

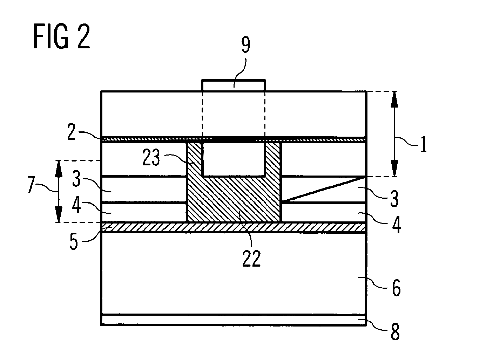

In Figur 2 ist eine schematische Schnittansicht eines zweiten Ausführungsbeispiels eines erfindungsgemäßen strahlungemittierenden Halbleiterbauelements gezeigt.

Dieses unterscheidet sich von dem in Figur 1a gezeigten Ausführungsbeispiel im wesentlichen durch eine Isolationsschicht 22, die in einer Aussparung der Zwischenschicht 3 und der Metallschicht 4 angeordnet ist. Die Halbleiterschichtenfolge 1 kann ebenfalls wie in Figur 1b ausgeführt sein.

Diese elektrische Isolationsschicht 22, beispielsweise aus SiN, ist unter dem Bereich der aktiven Zone 2 angeordnet, der von der Elektrode 9, die beispielsweise ein absorbierendes Metall enthält, überdeckt bzw. abgeschattet wird, und verringert mit Vorteil den Stromanteil, der von der Elektrode 8 in diesen Bereich der aktiven Zone 2 fließt. Der von der Elektrode 9 überdeckte Bereich der Halbleiterschichtenfolge ist in Figur 2 gestrichelt dargestellt. Die Isolationsschicht kann mittels Sputtern oder Aufdampfen aufgebracht sein.

Aufgrund der Isolationsschicht wird in diesem Bereich nur eine verglichen mit dem restlichen Bereich der aktiven Zone 2 geringe Strahlungsleistung erzeugt. Der Strahlungsanteil, der von der Elektrode 9 absorbiert werden kann wird so vorteilhaft verringert und die Effizienz des Bauelements verglichen mit dem in Figur 1a gezeigten insgesamt weiter erhöht.

Die Aussparung muss dabei nicht zwingend durch die Metallschicht 4 und die Zwischenschicht 3 bis auf den Träger 6 reichen. Wesentlich ist nur, dass ein möglichst geringer Strom in den von der Elektrode 9 überdeckten Bereich der aktiven Zone 2 gelangt. Eine Aussparung in der Zwischenschicht oder der Metallschicht alleine kann hierfür bereits ausreichen.

Bevorzugt ist in der Halbleiterschichtenfolge mindestens ein, vorzugsweise die Elektrode umlaufender, Graben 23 ausgebildet, der eine Strahlungserzeugung in der aktiven Zone 2, die durch einen Stromfluss um die Isolationsschicht 22 herum erfolgen kann, unter der Elektrode 8 weiter verringert. Der Graben 23 ist zweckmäßigerweise mit dem Material der Isolationsschicht befüllt. Ein derartiger Graben kann aus der Halbleiterschichtenfolge, beispielsweise vor dem Aufbringen der Zwischenschicht, mittels eines Ätzverfahrens strukturiert werden. In Figur 2 erstreckt sich der Graben in vertikaler Richtung zwischen der aktiven Zone und der der Zwischenschicht zugewandten Seite der Halbleiterschichtenfolge, vorzugsweise von der Zwischenschicht bis zum Rand der aktiven Zone, um die Gefahr einer Beschädigung der aktiven Zone aufgrund der Strukturierung des Grabens zu verringern. Der vom Graben umschlossene Bereich der Halbleiterschichtenfolge ist besonders bevorzugt von dem verbleibenden Bereich über das Isolationsmaterial elektrisch getrennt.

Insgesamt kann mittels des ersten Spiegels eine RCLED realisiert werden, die eine externe Effizienz von 30% oder mehr, vorzugsweise bis zu 40 %, aufweist.

Es sei angemerkt, dass sich die Erfindung auch für einen effizienten VCSEL mit internem Resonator oder eine effiziente LED ohne Resonator mit einem ersten Spiegel eignet. Eine besonders hohe Effizienzsteigerung kann aber bei einer RCLED oder einem VECSEL erzielt werden.

Diese Patentanmeldung beansprucht die Priorität der deutschen Patentanmeldung DE 102004057802.8 vom 30. November 2004, deren gesamter Offenbarungsgehalt hiermit explizit durch Rückbezug in die vorliegende Patentanmeldung aufgenommen wird.

Die Beschreibung der Erfindung anhand der Ausführungsbeispiele ist nicht als eine Beschränkung der Erfindung auf diese anzusehen. Vielmehr umfasst die Erfindung alle Kombinationen von Merkmalen, die in den Ausführungsbeispielen, der sonstigen Beschreibung oder den Patentansprüchen genannt sind, auch wenn diese Kombinationen nicht Gegenstand eines Patentanspruchs sind.

**Patentansprüche**

1. Strahlungemittierendes Halbleiterbauelement, das eine Halbleiterschichtenfolge (1) mit einer zur Strahlungserzeugung vorgesehenen aktiven Zone (2) und einen ersten, der aktiven Zone nachgeordneten Spiegel aufweist, **dadurch gekennzeichnet, dass**

    - der erste Spiegel eine Metallschicht (4) und eine auf der der aktiven Zone zugewandten Seite der Metallschicht (4) angeordnete Zwischenschicht (3) aus einem strahlungsdurchlässigen und elektrisch leitfähigen Material umfasst, wobei

- das strahlungemittierende Halbleiterbauelement zum Betrieb mit einem optischen Resonator und zur Erzeugung inkohärenter Strahlung als RCLED oder zum Betrieb mit einem externen optischen Resonator und zur Erzeugung kohärenter Strahlung als VECSEL vorgesehen ist.

2. Strahlungemittierendes Halbleiterbauelement nach Anspruch 1,
   **dadurch gekennzeichnet, dass** die Zwischenschicht (3) wenigstens teilweise derart ausgebildet ist, dass sich ein an der Metallschicht (4) reflektierter Strahlungsanteil und ein an der der Halbleiterschichtenfolge (1) zugewandten Seite der Zwischenschicht (3) reflektierter Strahlungsanteil konstruktiv überlagern.

3. Strahlungemittierendes Halbleiterbauelement nach Anspruch 1 oder 2,
   **dadurch gekennzeichnet, dass** die Zwischenschicht (3) eine Dicke D aufweist, die der Beziehung

$$D = \frac{\lambda}{4n_z} + k \cdot \frac{\lambda}{2n_z} - 1$$

genügt, wobei $\lambda$ die Vakuumwellenlänge der in der aktiven Zone (2) erzeugten Strahlung, $n_z$ den Brechungsindex der Zwischenschicht (3), k eine natürliche Zahl einschließlich Null und 1 eine endliche, von Null verschiedene Restlänge bezeichnen.

4. Strahlungemittierendes Halbleiterbauelement nach Anspruch 3,
   **dadurch gekennzeichnet, dass** die Restlänge 1 kleiner als ein Viertel der Wellenlänge $\lambda$' ($\lambda/n_z$), bevorzugt kleiner als ein Achtel der Wellenlänge $\lambda$', ist, wobei $\lambda$' die Wellenlänge der in der aktiven Zone (2) erzeugten Strahlung in der Zwischenschicht (3) bezeichnet.

5. Strahlungemittierendes Halbleiterbauelement nach mindestens einem der vorhergehenden Ansprüche,
   **dadurch gekennzeichnet, dass** die Zwischenschicht ein Oxid, insbesondere ein Metalloxid, enthält.

6. Strahlungemittierendes Halbleiterbauelement nach mindestens einem der vorhergehenden Ansprüche,
   **dadurch gekennzeichnet, dass** der erste Spiegel (7) einen Braggspiegel (19) umfasst.

7. Strahlungemittierendes Halbleiterbauelement nach mindestens einem der vorhergehenden Ansprüche,
   **dadurch gekennzeichnet, dass** die Metallschicht (4) Au und die Zwischenschicht (3) ZnO enthält.

8. Strahlungemittierendes Halbleiterbauelement nach Anspruch 6 oder 7,
   **dadurch gekennzeichnet, dass** der Braggspiegel (19) auf der der aktiven Zone (2) zugewandten Seite der Zwischenschicht (3) angeordnet ist.

9. Strahlungemittierendes Halbleiterbauelement nach mindestens einem der Ansprüche 6 bis 8,
   **dadurch gekennzeichnet, dass** der Braggspiegel (19) nicht mehr als 20, bevorzugt nicht mehr als 6, besonders bevorzugt nicht mehr als 4 Halbleiterschichtenpaare aufweist.

10. Strahlungemittierendes Halbleiterbauelement nach mindestens einem der vorhergehenden Ansprüche, **dadurch gekennzeichnet, dass** der Resonator den ersten Spiegel (7) und einen zweiten Spiegel (13) aufweist, wobei der zweite Spiegel auf der dem ersten Spiegel gegenüberliegenden Seite der aktiven Zone (2) angeordnet ist.

11. Strahlungemittierendes Halbleiterbauelement nach mindestens einem der vorhergehenden Ansprüche,
    **dadurch gekennzeichnet, dass** das Halbleiterbauelement als RCLED ausgeführt ist und der optische Resonator ein interner Resonator ist.

12. Strahlungemittierendes Halbleiterbauelement nach Anspruch 10 oder 11, **dadurch gekennzeichnet, dass** die Reflektivität des ersten Spiegels (7) größer ist als die Reflektivität des zweiten Spiegels (13).

13. Strahlungemittierendes Halbleiterbauelement nach einem der Ansprüche 10 bis 12, **dadurch gekennzeichnet, dass** die Strahlung aus dem Halbleiterbauelement durch den zweiten Spiegel ausgekoppelt wird.

14. Strahlungemittierendes Halbleiterbauelement nach einem der Ansprüche 10 bis 13, **dadurch gekennzeichnet,**

**dass** der zweite Spiegel als Braggspiegel ausgeführt ist.

**15.** Strahlungemittierendes Halbleiterbauelement nach mindestens einem der Ansprüche 6 bis 14, **dadurch gekennzeichnet, dass** der beziehungsweise die Braggspiegel ein III-V-Halbleitermaterial, vorzugsweise $In_xGa_yAl_{1-x-y}P$, $In_xGa_yAl_{1-x-y}N$ oder $In_xGa_yAl_{1-x-y}As$, jeweils mit $0 \leq x \leq 1$, $0 \leq y \leq 1$ und $x+y \leq 1$, enthält beziehungsweise enthalten.

**16.** Strahlungemittierendes Halbleiterbauelement nach mindestens einem der vorhergehenden Ansprüche, **dadurch gekennzeichnet, dass** eine Wellenlänge der in der aktiven Zone erzeugten Strahlung im sichtbaren, insbesondere roten, Spektralbereich liegt.

**17.** Strahlungemittierendes Halbleiterbauelement nach mindestens einem der vorhergehenden Ansprüche, **dadurch gekennzeichnet, dass** die Halbleiterschichtenfolge (1) auf einem Träger (6) angeordnet ist.

**18.** Strahlungemittierendes Halbleiterbauelement nach Anspruch 17, **dadurch gekennzeichnet, dass** der Träger (6) von einem Aufwachssubstrat (10) der Halbleiterschichtenfolge (1) verschieden ist.

**19.** Strahlungemittierendes Halbleiterbauelement nach Anspruch 17 oder 18, **dadurch gekennzeichnet, dass** der Träger (6) eine Wärmesenke umfasst.

**20.** Strahlungemittierendes Halbleiterbauelement nach mindestens einem der vorhergehenden Ansprüche, **dadurch gekennzeichnet, dass** auf der dem ersten Spiegel abgewandten Seite der aktiven Zone eine Kontaktstruktur (8,9) zur elektrischen Kontaktierung des Halbleiterbauelements angeordnet ist.

**21.** Strahlungemittierendes Halbleiterbauelement nach Anspruch 20, **dadurch gekennzeichnet, dass** unter dem Bereich der aktiven Zone, der von der Kontaktstruktur (8,9) überdeckt wird, ein elektrisches Isolationsmaterial angeordnet ist.

**22.** Strahlungemittierendes Halbleiterbauelement nach mindestens einem der vorhergehenden Ansprüche, **dadurch gekennzeichnet, dass** das strahlungemittierende Halbleiterbauelement ein Dünnfilm-Bauelement ist.

**23.** Strahlungemittierendes Halbleiterbauelement nach mindestens einem der vorhergehenden Ansprüche, **dadurch gekennzeichnet, dass** die Halbleiterschichtenfolge (1), insbesondere die aktive Zone, mindestens ein III-V-Halbleitermaterial, vorzugsweise ein Material aus den Materialsystemen $In_xGa_yAl_{1-x-y}P$, $In_xGa_yAl_{1-x-y}N$ oder $In_xGa_yAl_{1-x-y}As$, jeweils mit $0 \leq x \leq 1$, $0 \leq y \leq 1$ und $x+y \leq 1$, enthält.

FIG 1A

FIG 1B

FIG 2